# EUROPEAN PATENT SPECIFICATION

(11) **EP 3 445 041 B1**
(45) Date of publication and mention of the grant of the patent: **24.03.2021**
(21) Application number: 17782109.7
(22) Date of filing: 16.02.2017
(51) Int. Cl.: H04N 5/378, G01T 1/17, G01T 1/20, G01T 1/24, H01L 27/144, H04N 5/32, H04N 5/357, H04N 5/374, H04N 5/376

(54) **RADIATION DETECTOR**
STRAHLUNGSDETEKTOR
DÉTECTEUR DE RAYONNEMENT

(30) Priority: 15.04.2016 JP 2016081957
(43) Date of publication of application: 20.02.2019
(73) Proprietor: Canon Electron Tubes & Devices Co., Ltd., Otawara-shi, Tochigi (JP)
(72) Inventor: FUJITA, Shuichi, Otawara-shi Tochigi 324-8550 (JP)
(74) Representative: Henkel & Partner mbB
(86) International application number: PCT/JP2017/005653
(87) International publication number: WO 2017/179290

(56) References cited:
- WO-A1-2011/161988
- DE-A1-102006 008 886
- JP-A- 2005 087 254
- JP-A- 2011 130 362
- JP-A- 2013 070 168
- US-A1- 2005 062 864

## Description

### [Technical Field]

Embodiments of the invention relate to a radiation detector.

### [Background Art]

A radiation detector is provided with an array substrate including many pixels, a drive control circuit applying a control signal to the pixel, a read control circuit processing an image data signal from the pixel, and an image processing circuit configuring a radiation image from the image data signal or the like.

Here, if a switching noise (low frequency noise) generated in a power supply circuit, a digital noise (high frequency noise) generated in a digital circuit provided in the drive control circuit and the read control circuit etc., a noise (high frequency noise) generated from skew of a signal intrude in the read control circuit or the like, there is a fear that quality of the obtained radiation image is remarkably deteriorated.

In this case, the noise intruding through a power supply line can be reduced by providing a filter on the power supply line.

However, since the ground line is common, the noise intruding through the ground line cannot be removed.

In this case, if a switching cycle of the power supply circuit and a scan cycle of the drive control circuit and the read control circuit are matched strictly, the noise can be inconspicuous. However, in the case where noise components change due to timing jitter and drift, there is a fear that a sufficient effect cannot be obtained. In the image processing circuit or the like, processing synchronizing with the scan frequency may not be performed. In the case where the processing synchronizing with the scan frequency is not performed, a random noise and a striped noise appear on the radiation image.

Furthermore, in such a way, the noise intruding through the commonized ground line cannot be removed.

For that reason, development of a radiation detector which can reduce the influence of noises on a radiation image has been desired.

### [Prior Art Document]

### [Patent Document]

[Patent Document 1] JP 2005-87254 A (Kokai)
[Patent Document 2] JP 2011 130362 A
[Patent Document 3] US 2005/062864 A1
[Patent Document 4] DE 10 2006 008886 A1

### [Summary of Invention]

### [Problem to be Solved by Invention]

The problem to be solved by the invention is to provide a radiation detector which can reduce the influence of noises on a radiation image.

### [Means for Solving Problem]

Accordingly, there is provided a radiation detector as set out in independent claim 1. An advantageous development is defined in the dependent claim 2.

### [Brief Description of Drawings]

[FIG. 1]

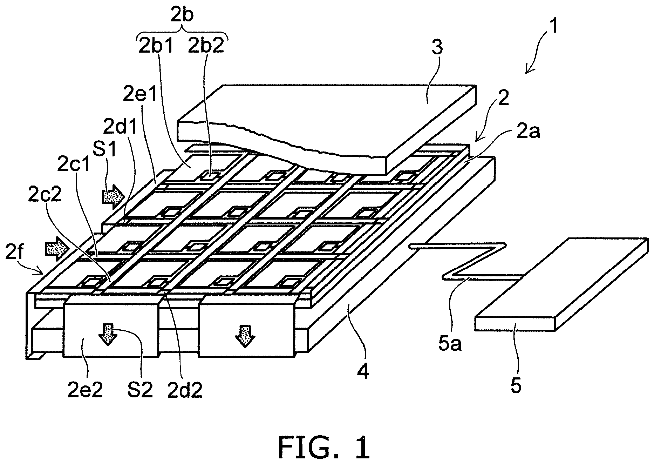

   FIG. 1 is a schematic perspective view for illustrating an X-ray detector 1.
[FIG. 2]

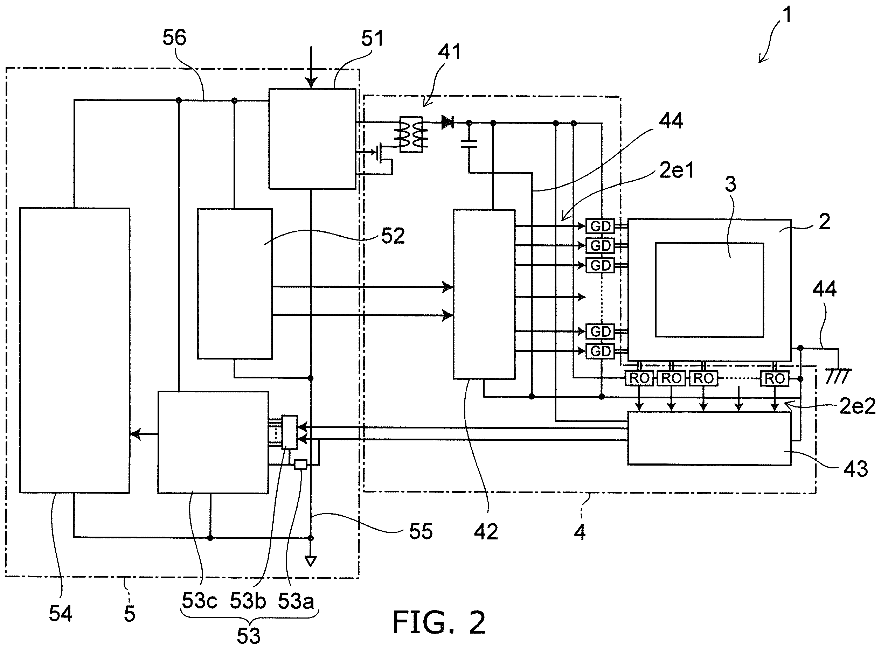

   FIG. 2 is a block diagram of the X-ray detector 1.
[FIG. 3]

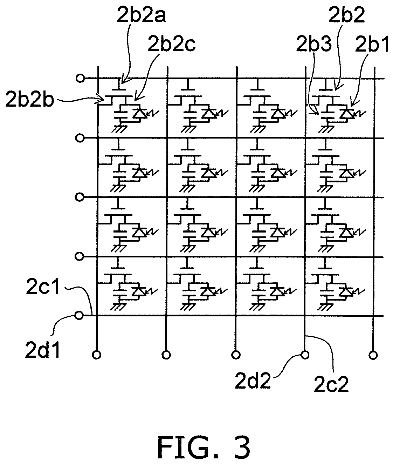

   FIG. 3 is a circuit diagram of an array substrate 2.
[FIG. 4]

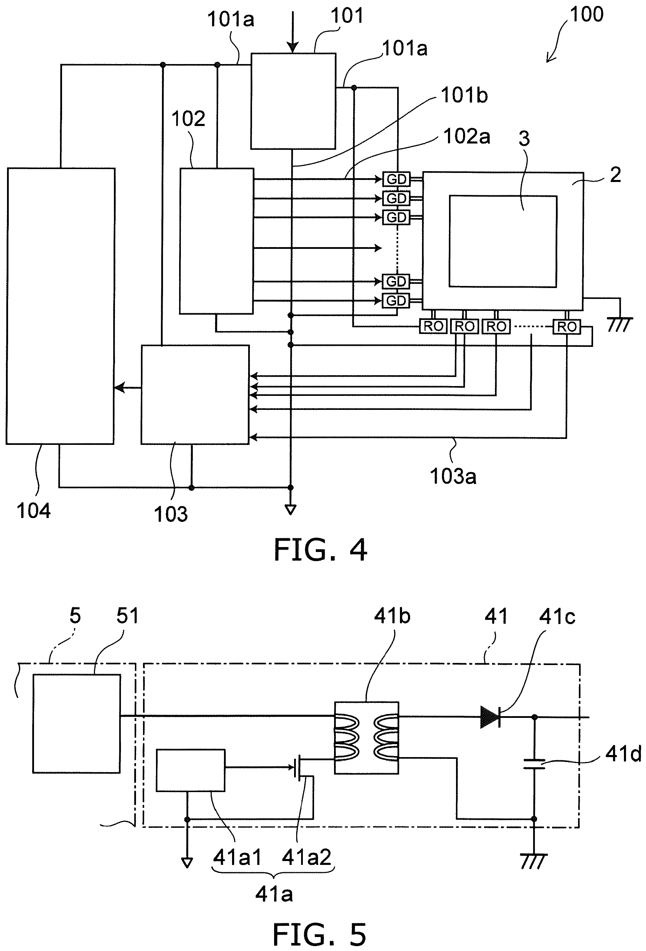

   FIG. 4 is a block diagram of an X-ray detector 100 according to a comparative example.
[FIG. 5]
   FIG. 5 is a block diagram of a power supply circuit 41.
[FIG. 6]

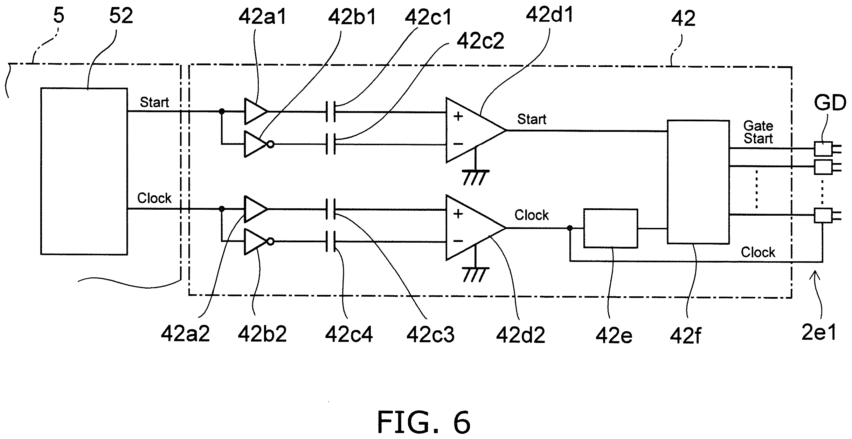

   FIG. 6 is a block diagram of a drive timing generating circuit 42.
[FIG. 7]

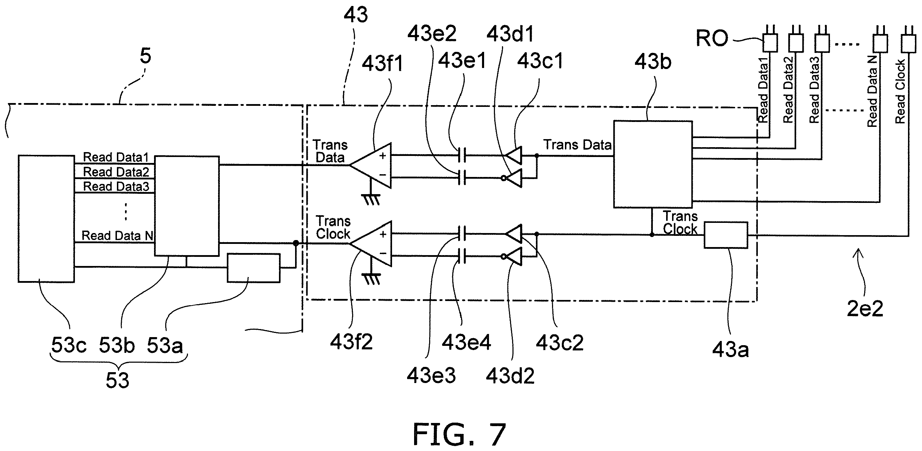

   FIG. 7 is a block diagram of an image data signal transfer circuit 43.
[FIG. 8]

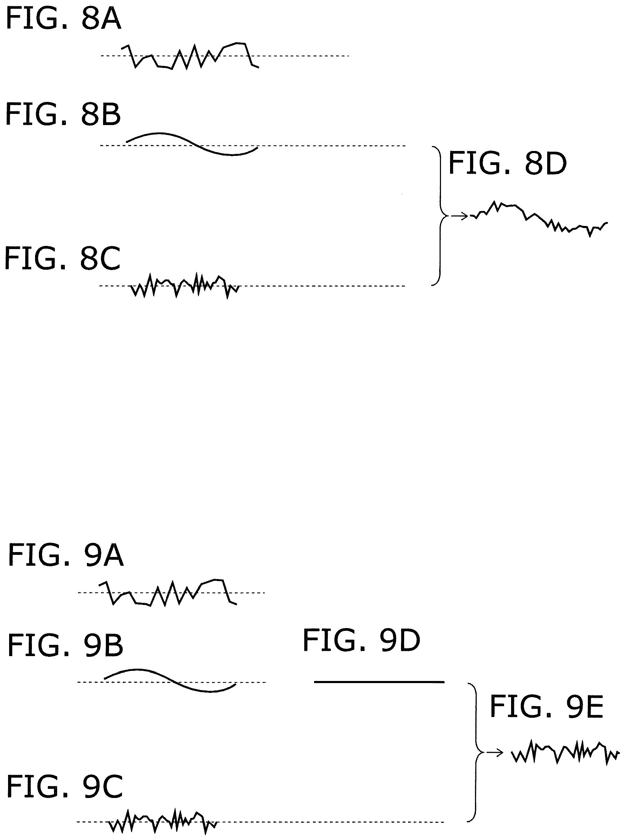

   FIGS. 8A to 8D are graph views for illustrating noises in the X-ray detector 100 according to the comparative example.
[FIG. 9]
   FIGS. 9A to 9E are graph views for illustrating noises in the case where the power supply circuit 41 is provided.
[FIG. 10]

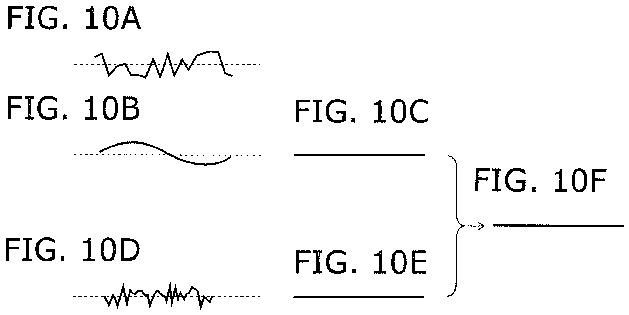

   FIGS. 10A to 10F are graph views for illustrating noises in the case where the power supply circuit 41, the drive timing generating circuit 42 and the image data signal transfer circuit 43 are provided.

### [Embodiments of Invention]

Embodiments will be illustrated with reference to the accompanying drawings. In the drawings, similar components are marked with like reference numerals, and the detailed description is omitted as appropriate.

The radiation detector according to the embodiment can be applied to various radiations such as a y-ray other than an X-ray. Here, the case of the X-ray as a representative of radiations is described as one example. Therefore, the radiation detector can also be applied to other radiation by replacing "X-ray" of the following embodiments with "other radiation".

The X-ray detector 1 illustrated below is an X-ray plane sensor detecting an X-ray image which is a radiation image. The X-ray plane sensor includes a direct conversion method and an indirect conversion method broadly.

The direct conversion method is a method that a photoconductive charge (signal charge) generated inside a photoconductive film by the incident X-ray is introduced directly to a storage capacitor for charge storage by a high electric field.

The indirect conversion method is a method that the X-ray is converted to fluorescence (visible light) by a scintillator, the fluorescence is converted to the signal charge by a photoelectric conversion element such as a photodiode, and the signal charge is introduced to the storage capacitor.

In the following, the X-ray detector 1 of the indirect conversion method is illustrated as one example, however the invention can also be applied to the X-ray detector of the indirect conversion method.

That is, the X-ray detector may be a detector including a detection part that detects the X-ray directly or in cooperation with the scintillator.

The X-ray detector 1 can be used for, for example, general medical application or the like, and the application is not limited.

FIG. 1 is a schematic perspective view for illustrating the X-ray detector 1.

FIG. 2 is a block diagram of the X-ray detector 1.

FIG. 3 is a circuit diagram of an array substrate 2.

As shown in FIG. 1 to FIG. 3, the X-ray detector 1 is provided with the array substrate 2, a scintillator 3, a signal processing part 4, and a control processing part 5.

The array substrate 2 converts the fluorescence (visible light) converted from the X-ray by the scintillator 3 to an electrical signal.

The array substrate 2 includes a substrate 2a, a photoelectric conversion part 2b, a control line (or a gate line) 2c1, and a data line (or a signal line) 2c2.

The substrate 2a is plate-shaped, and is formed of a light transmissive material such as a non-alkali glass.

The photoelectric conversion part 2b is provided multiply on one surface of the substrate 2a.

The photoelectric conversion part 2b is rectangle-shaped, and is provided in a region drawn by the control line 2c1 and the data line 2c2. The multiple photoelectric conversion parts 2b are arranged in a matrix configuration.

One photoelectric conversion part 2b corresponds to one picture element (pixel).

The photoelectric conversion par 2b serves as a detection part cooperating with the scintillator 3 to detect the X-ray.

Each of the multiple photoelectric conversion parts 2b is provided with a photoelectric conversion element 2b1, and a thin film transistor (TFT) 2b2 which is a switching element.

As shown in FIG. 3, a storage capacitor 2b3 which stores the signal charge converted in the photoelectric conversion element 2b1 can be provided. The storage capacitor 2b3 is, for example, rectangular flat plate-shaped, and can be provided under the respective thin film transistors 2b2. However, depending on a capacity of the photoelectric conversion element 2b1, the photoelectric conversion element 2b1 can serve as the storage capacitor 2b3.

The photoelectric conversion element 2b1 can be, for example, a photodiode or the like.

The thin film transistor 2b2 performs switching of storing and release of a charge generated by incidence of the fluorescence to the photoelectric conversion element 2b1. The thin film transistor 2b2 can include a semiconductor material such as amorphous silicon (a-Si) and polysilicon (P-Si). The thin film transistor 2b2 includes a gate electrode 2b2a, a source electrode 2b2b and a drain electrode 2b2c. The gate electrode 2b2a of the thin film transistor 2b2 is electrically connected to the corresponding control line 2c1. The source electrode 2b2b of the thin film transistor 2b2 is electrically connected to the corresponding data line 2c2. The drain electrode 2b2c of the thin film transistor 2b2 is electrically connected to the corresponding photoelectric conversion element 2b1 and the storage capacitor 2b3.

The control line 2c1 is provided multiply to be parallel to each other with a prescribed spacing. The control lines 2c1 extend, for example, in a row direction (corresponding to one example of a first direction).

One control line 2c1 is electrically connected to one of multiple wiring pads 2d1 provided near the periphery of the substrate 2a. One of multiple wirings provided on a flexible print board 2e1 is electrically connected to one wiring pad 2d1. Other ends of the multiple wirings provided on the flexible print board 2e1 are electrically connected to gate drivers GD provided on the signal processing part 4, respectively.

The data line 2c2 is provided multiply to be parallel to each other with a prescribed spacing. The data lines 2c2 are, for example, in a row direction orthogonal to the column direction (corresponding to one example of a second direction).

One data line 2c2 is electrically connected to one of multiple wiring pads 2d2 provided near the periphery of the substrate 2a. One of multiple wirings provided on a flexible print board 2e2 is electrically connected to one wiring pad 2d2. Other ends of the multiple wirings provided on the flexible print board 2e2 are electrically connected to reading circuits RO provided on the signal processing part 4.

The control line 2c1 and the data line 2c2 can be formed based on, for example, a low resistance metal such as aluminum and chromium or the like.

A protection layer 2f covers the photoelectric conversion part 2b, the control line 2c1, and the data line 2c2.

The protection layer 2f includes, for example, at least one of an oxide insulating material, a nitride insulating material, an oxynitride insulating material, or a resin material.

The oxide insulating material is, for example, silicon oxide, and aluminum oxide or the like.

The nitride insulating material is, for example, silicon nitride, and aluminum nitride or the like.

The oxynitride insulating material is, for example, silicon oxynitride or the like.

The resin material is, for example, an acrylic resin.

The scintillator 3 is provided on the multiple photoelectric conversion elements 2b1, and converts the incident X-ray to visible light, namely the fluorescence. The scintillator 3 is provided to cover a region (effective pixel region) where the multiple photoelectric conversion parts 2b on the substrate 2a are provided.

The scintillator 3 can be formed based on, for example, cesium iodide (CsI):thallium (Tl), or sodium iodide (NaI):thallium (Tl) or the like. In this case, if the scintillator 3 is formed by using a vacuum deposition method or the like, the scintillator 3 made of multiple columnar crystal aggregations is formed.

A thickness dimension of the scintillator 3 can be, for example, about 600 µm. A thickness dimension of the pillar of the columnar crystal can be, for example, approximately 8 µm to 12 µm at an outermost surface.

The scintillator 3 can also be formed based on, for example, gadolinium oxysulfide (Gd₂O₂S) or the like. In this case, for example, the scintillator 3 can be formed as follows. First, particles made of gadolinium oxysulfide are mixed with a binder material. Next, the mixed material is coated to cover the effective pixel region. Next, the coated material is fired. Next, grooves are formed in the fired material using a blade dicing method or the like. At this time, the grooves in a matrix configuration can be formed so that the square pillar-shaped scintillator 3 is provided for every multiple photoelectric conversion elements 5. The grooves can be filled with atmosphere (air) or inactive gas such as antioxidant nitrogen gas or the like. The grooves may be in a vacuum state.

Other, in order to increase a utilization efficiency of the fluorescence and improve sensitivity characteristics, a reflection layer not shown can be provided so as to cover a surface side (an incident surface side of the X-ray) of the scintillator 3.

In order to suppress the characteristics of the scintillator 3 and the characteristics of the reflection layer not shown from being deteriorated by water vapor included in air, a moisture proof body not shown covering the scintillator 3 and the reflection layer not shown can be provided.

Here, an X-ray detector 100 according to a comparative example will be described before describing the signal processing part 4 and the control processing part 5.

FIG. 4 is a block diagram of the X-ray detector 100 according to the comparative example.

As shown in FIG. 4, the X-ray detector 100 is provided with the array substrate 2, the scintillator 3, a system power supply circuit 101, a drive control circuit 102, a read control circuit 103, and an image processing circuit 104.

The system power supply circuit 101 includes a DC/DC converter, and converts a DC voltage supplied from the outside to a prescribed DC voltage. The system power supply circuit 101 applies the converted DC voltage to the drive control circuit 102, the read control circuit 103, the image processing circuit 104, the gate derivers GD, and the reading circuits RO.

The drive control circuit 102 transmits a control signal to the corresponding gate driver GD in accordance with a scanning direction of the X-ray image.

When the control signal from the drive control circuit 102 is received, the gate driver GD applies a voltage to the corresponding control line 2c1.

Each of the multiple reading circuits RO includes an integrating amplifier and an analog-digital converter. The reading circuits RO amplify the read image data signal and convert the amplified image data signal (analog signal) to a digital signal. The image data signal converted to the digital signal is transmitted to the read control circuit 103.

The read control circuit 103 transmits the received image data signal to the image processing circuit 104.

The image processing circuit 104 configures the X-ray image on the basis of the image data signal from the read control circuit 103.

Here, the DC/DC converter provided in the system power supply circuit 101 is possible to generate the prescribed DC voltage by switching a current, however generates a switching noise (low frequency noise) when switching. If the generated switching noise intrudes in the photoelectric conversion element 2b1 and the thin film transistor 2b2 provided in the photoelectric conversion part 2b, or the analog circuit such as the integrating amplifier provided in the reading circuit RO via a power supply line 101a and a ground line 101b, there is a fear that the quality of the obtained X-ray image is deteriorated.

In this case, if a filter is provided in the power supply line 101a, the noise intruding in the noise sensitive analog circuit (for example, reading circuit RO) can be reduced via the power supply line 101a. However, as shown in FIG. 4, since the ground line 101b is common, the noise intruding in the analog circuit via the ground line 101b cannot be removed.

The number of the photoelectric conversion parts 2b provided on the array substrate 2 is about a few millions. For that reason, many gate drivers GD and reading circuits RO are necessary, and a complicated large-scale digital circuit for controlling the many gate drivers GD and the reading circuits RO is necessary.

In the digital circuit, the digital noise of a high frequency is generated. If the generated digital noise intrudes in the analog circuit such as the integrating amplifier provided in the reading circuit RO via signal lines 102a, 103a and the ground line 101b, there is a fear that the quality of the obtained X-ray image is extremely deteriorated.

The number of the signal lines 102a, 103a is reduced by performing 2-dimensional scanning, however a few ten to a few hundred signal lines 102a, 103a are necessary for connection of the gate drivers GD and the drive control circuit 102 and connection of the reading circuits RO and the read control circuit 103. For that reason, a noise due to skew of the signal is easily to be generated. If the generated noise intrudes in the analog circuit such as the integrating amplifier provided in the reading circuit RO via the ground line 101b, there is a fear that the quality of the obtained radiation image is extremely deteriorated.

For that reason, in the X-ray detector 1 according to the embodiment, the signal processing part 4 and the control processing part 5 are made to be isolated in DC. The number of the signal lines is further reduced.

As shown in FIG. 1, the signal processing part 4 is provided on an opposite side of the array substrate 2 from a side on which the scintillator 3 is provided.

As shown in FIG. 2, the signal processing part 4 is provided with a power supply circuit 41, a drive timing generating circuit 42, an image data signal transfer circuit 43, the multiple gate drivers GD, and the multiple reading circuits RO.

The multiple gate drivers GD are electrically connected to the multiple control lines 2c1, respectively.

The multiple reading circuits RO are electrically connected to the multiple data lines 2c2, respectively.

FIG. 5 is a block diagram of the power supply circuit 41.

As shown in FIG. 5, the power supply circuit 41 is provided with a DC-AC conversion part 41a, a transformer 41b, a rectifier 41c, and a capacitor 41d (corresponding to one example of a third capacitor).

The DC-AC conversion part 41a converts a DC voltage supplied from the system power supply circuit 51 to an AC voltage.

The DC-AC conversion part 41a includes an oscillation circuit 41a1 and a switching element 41a2.

The oscillation circuit 41a1 performs ON/OFF of the switching element 41a2 at a prescribed frequency.

The switching element 41a2 supplies a pulsed current to the primary side of the transformer 41b by switching the current. The switching element 41a2 can be, for example, a bipolar transistor, am insulating gate bipolar transistor (IGBT), MOSFET, a gate turn off thyristor (GTO) or the like.

The primary side of the transformer 41b is electrically connected to the DC-AC conversion part 41a, and the secondary side is electrically connected to the multiple reading circuits RO.

The transformer 41b can be, for example, an insulating transformer, a shield transformer or the like.

The rectifier 41c is electrically connected between the secondary side of the transformer 41b and the multiple reading circuits RO. The rectifier 41c rectifies an AC current flowing in the secondary side of the transformer 41b. The rectifier 41c converts the AC voltage to the DC voltage on the secondary side of the transformer 41b.

The capacitor 41d is electrically connected between the rectifier 41c and a ground line 44.

Since the power supply circuit 41 is provided with the transformer 41b, the signal processing part 4 and the system power supply circuit 51 of the control processing part 5 can be isolated in DC. For that reason, the switching noise (low frequency noise) generated in the DC/DC converter provided in the system power supply circuit 51 can be suppressed from intruding in the photoelectric conversion part 2b1 and the thin film transistor 2b2 provided in the photoelectric conversion part 2b by the transformer 41b. The switching noise generated in the DC-AC conversion part 41a can be suppressed from intruding in the photoelectric conversion element 2b1 and the thin film transistor 2b2 provided in the photoelectric conversion part 2b.

Since the power supply circuit 41 is supplied with the capacitor 41d, the noise can be suppressed from intruding in the photoelectric conversion element 2b1 and the thin film transistor 2b2 provided in the photoelectric conversion part 2b via the ground line 44.

FIG. 6 is a block diagram of the drive timing generating circuit 42.

The drive timing generating circuit 42 is electrically connected between the drive control circuit 52 and the multiple gate drivers GD.

The drive timing generating circuit 42 restores serial data (corresponding to one example of first serial data) from the drive control circuit 52 described later to multiple start signals (signals for instructing a timing of scanning start) and multiple clock signals (signals for switching the control line 2c1), and transmits the restored start signals and clock signals to the corresponding gate drivers GD.

As shown in FIG. 6, the drive timing generating circuit 42 is provided with buffers 42a1, 42a2, inverters 42b1, 42b2, capacitors 42c1, 42c2, 42c3, 42c4 (corresponding to one example of the first capacitor), operational amplifiers 42d1, 42d2, a dividing circuit 42e, and a shift register 42f.

The start signal transmitted from the drive control circuit 52 is input to the buffer 42a1 and the inverter 42b1. The buffer 42a1 is not always necessary and can also be omitted. The inverter 42b1 inverts the received start signal. The operational amplifier 42d1 re-generates the start signals by calculating a difference between the start signal from the buffer 42a1 which is received via the capacitor 42c1 and inverted signal from the inverter 42b1 which is received via the capacitor 42c2.

The clock signal transmitted from the drive control circuit 52 is input to the buffer 42a2 and the inverter 42b2. The buffer 42a2 is not always necessary and can also be omitted. The inverter 42b2 inverts the received clock signal. The operational amplifier 42d2 re-generates the clock signals by calculating a difference between the clock signal from the buffer 42a2 which is received via the capacitor 42c3 and inverted signal from the inverter 42b2 which is received via the capacitor 42c4. The re-generated clock signals are transmitted to the dividing circuit 42e and the gate drivers GD. The dividing circuit 42e converts the received clock signals to clock signals having a prescribed frequency, and transmits to the shift register 42f.

The shift register 42f generates control signals S1 for each of the multiple gate drivers GD from the start signals from the operational amplifier 42d1 and the clock signals from the dividing circuit 42e. The shift register 42f transmits sequentially the generated control signals S1 to the respective gate drivers GD.

When the gate drivers GD receive the control signals S1, a voltage is applied to the corresponding control line 2c1. When the voltage is applied to the control line 2c1, the thin film transistor 2b2 is turned ON, and is able to receive the signal charges (image data signals S2) from the photoelectric conversion element 2b1.

Here, the drive timing generating circuit 42 includes the capacitors 42c1, 42c2, 42c3, 42c4 on a side at which the serial data are received. For that reason, the signal processing part 4 and the control processing part 5 can be isolated in DC. As a result, the low frequency noise can be suppressed from intruding in the control processing part 5 from the signal processing part 4.

In the case of the drive control circuit 102 provided in the X-ray detector 100 according to the comparative example, the start signals and the clock signals are generated with reference to the ground potential. For that reason, the drive control circuit 102, the system power supply circuit 101, and the gate drivers GD are connected to the common ground line 101b. As a result, there is a fear that the switching noise generated in the system power supply circuit 101 intrudes in the gate drivers GD via the ground line 101b.

On the contrary, in the case of the drive timing generating circuit 42, the start signals and the clock signals are generated with reference to the inverted signals generated by the inverters 42b1, 42b2. For that reason, a ground line 55 with the system power supply circuit 51 connected and a ground line 44 with the drive control circuit 42 and the gate drivers GD connected are isolated. As a result, it is possible to suppress the switching noise generated in the system power supply circuit 51 from intruding in the gate drivers GD.

The drive control circuit 52 and the drive timing generating circuit 42 should be connected by two signal lines, and thus the noise generation due to skew of the signal can be suppressed. The drive control circuit 52 does not need the complex large-scale digital circuit for generating the signals for many gate drivers GD, and thus the digital circuit provided in the drive control circuit 52 can be simplified. For that reason, in the drive control circuit 52, generation of a high frequency digital noise can be suppressed.

FIG. 7 is a block diagram of the image data signal transfer circuit 43.

The image data signal transfer circuit 43 converts the image data signal S2 from each of the multiple reading circuits RO to the serial data (corresponding to one example of the second serial data).

As shown in FIG. 7, the image data signal transfer circuit 43 is provided with a multiplying circuit 43a, a parallel-serial conversion circuit 43b, buffers 43c1, 43c2, inverters 43d1, 43d2, capacitors 43e1, 43e2, 43e3, 43e4 (corresponding to one example of the second capacitor), operational amplifiers 43f1, 43f2.

First, N pieces of the image data signals S2 are read by N pieces of the reading circuits RO. The image data signals S2 are output in synchronization with the read out clock signal.

Each of the N pieces of the reading circuits RO includes an integrating amplifier and an analog-digital converter. The reading circuit RO amplifies the read image data signal S2, and converts the amplified image data signal S2 (analog signals) to digital signal. The image data signal S2 which is converted to the digital signal is transmitted to the parallel-serial conversion circuit 43b.

The multiplying circuit 43a generates transfer clock signal having N times frequency of the frequency of the read out clock signal. The transfer clock signal is transmitted to the parallel-serial conversion circuit 43b, the buffer 43c2, and the inverter 43d2.

The parallel-serial conversion circuit 43b sequentially outputs the image data signal S2 selectively from the N pieces of the image data signals S2 in accordance with the transfer clock signal. That is, the parallel-serial conversion circuit 43b converts the N pieces of parallel data to the serial data.

The converted serial data (the image data signals S2) are input to the buffer 43c1 and the inverter 43d1. The buffer 43c1 is not always necessary, and can also be omitted. The inverter 43d1 inverts the received signal. The operational amplifier 43f1 generates the transfer data for transmitting to the control processing part 5 by calculating a difference between the signal from the buffer 43c1 which is received via the capacitor 43e1 and the inverted signal from the inverter 43d1 which is received via the capacitor 43e2.

The transfer signal is input to the buffer 43c2 and the inverter 43d2. The buffer 43c2 is not always necessary, and can also be omitted. The inverter 43d2 inverts the received transfer clock signal. The operational amplifier 43f2 generates the transfer clock signal for transmitting to the control processing part 5 by calculating a difference between the transfer clock signal from the buffer 43c2 which is received via the capacitor 43e3 and the inverted signal from the inverter 43d2 which is received via the capacitor 43e4.

The image data signal transfer circuit 43 includes the capacitors 43e1, 43e2, 43e3, 43e4 on a side of transmitting the serial data. For that reason, the signal processing part 4 and the control processing part 5 can be isolated in DC. As a result, the low frequency noise can be suppressed from intruding in the control processing part 5 from the signal processing part 4.

In the case of the X-ray detector 100 according to the comparative example, the data signal for transmitting to the read control circuit 103 is generated with reference to the ground potential. For that reason, the system power circuit 101, the read control circuit 103, and the reading circuits RO are connected to the common ground line 101b. As a result, there is a fear that the switching noise generated in the system power supply circuit 101 intrudes in the reading circuits RO via the ground line 101b.

On the contrary, in the case of the image data signal transfer circuit 43, the transfer signal and the clock signal are generated with reference to the inverted signal generated by the inverters 43d1, 43d2. For that reason, the ground line 55 with the system power supply circuit 51 connected and the ground line 44 with the image data signal transfer circuit 43 and the reading circuits RO connected are isolated. As a result, it is possible to suppress the switching noise generated in the system power supply circuit 51 from intruding in the reading circuits RO.

The read control circuit 53 and the image data signal transfer circuit 43 should be connected by two signal lines, and thus the noise generation due to skew of the signal can be suppressed. The read control circuit 53 does not need the complex large-scale digital circuit for processing the signals from many reading circuits RO, and thus the digital circuit provided in the read control circuit 53 can be simplified. Therefore, in the read control circuit 53, generation of high frequency digital noise can be suppressed.

As shown in FIG. 2, the control processing part 5 is provided with the system power supply circuit 51, the drive control circuit 52, the read control circuit 53, and the image processing circuit 54.

The system power supply circuit 51 includes a DC/DC converter or the like, and converts a DC voltage supplied from the outside to a DC voltage. The system power supply circuit applies the converted DC voltage to the power supply circuit 41, the drive control circuit 52, the read control circuit 53, and the image processing circuit 54.

The drive control circuit 52 generates the start signal and the clock signal for each of the multiple gate drivers GD. The drive control circuit 52 converts the generated multiple start signals and the multiple clock signals to serial data. The drive control circuit 52 transmits the serial data to the drive timing generating circuit 42.

The read control circuit 53 converts the serial data from the image data signal transfer circuit 43 to N pieces of the parallel data, and transmits the converted parallel data to the image processing circuit 54.

The read control circuit 53 restores the serial data from the image data signal transfer circuit 43 to the multiple image data signals S2.

As shown in FIG. 7, the read control circuit 53 is provided with a dividing circuit 53a, a serial-parallel conversion circuit 53b, and a transmission circuit 53c.

The dividing circuit 53a generates the clock signal having a frequency 1/N times the frequency of the received transfer clock signal. The generated clock signal is transmitted to the serial-parallel conversion circuit 53b and the transmission circuit 53c.

The serial-parallel conversion circuit 53b converts the serial data (the image data signals S2) to N pieces of the parallel data.

The transmission circuit 53c transmits the converted parallel data to the image processing circuit 54.

The image processing circuit 54 configures the X-ray image on the basis of the image data signals S2 (parallel data) from the read control circuit 53.

Next, noise reducing effects will be described.

FIGS. 8A to 8D are graph views for illustrating noises in the X-ray detector 100 according to the comparative example.

FIG. 8A shows a switching noise (low frequency noise) in the power supply line 101a. FIG. 8B shows a switching noise (low frequency noise) in the ground line 101b. FIG. 8C shows a high frequency noise such as a digital noise generated on the control processing part 5 side and a noise generated by skew of the signal. FIG. 8D shows a synthesized noise in the ground line 101b.

As described previously, for the noise sensitive analog circuits (for example, the reading circuits RO), it is possible to reduce intruding noises via the power supply line 101a by providing a filter in the power supply line 101a. That is, the noise illustrated in FIG. 8A can be reduced.

However, as shown in FIG. 4, since the ground line 101b is common, the noise intruding via the ground line 101b cannot be removed. For that reason, the noises illustrated in FIGS. 8B, 8C cannot be reduced, and the noise illustrated in FIG. 8D intrudes in the reading circuits RO or the like via the ground line 101b.

FIGS. 9A to 9D are graph views for illustrating noises in the case of providing the power supply circuit 41.

FIG. 9A shows a switching noise (low frequency noise) in a power supply line 56. FIG. 9B shows a switching noise (low frequency noise) in the ground line 55. FIG. 9C shows a high frequency noise such as a digital noise generated on the control processing part 5 side and a noise generated by skew of the signal. FIG. 9D shows a state of the low frequency noise in the ground line 44. FIG. 9E shows a synthesized noise in the ground line 44.

If the power supply circuit 41 is provided, the ground line 44 of the signal processing part 4 and the ground line 55 of the control processing part 5 can be isolated. For that reason, as shown in FIG. 9D, it is possible to suppress the switching noise (low frequency noise) generated in the system power supply circuit 51 from intruding in the ground line 44.

In this case, the drive timing generating circuit 42 and the image data signal transfer circuit 43 are not provided, there is a fear that the high frequency noise illustrated in FIG. 9C intrudes in the ground line 44. If the high frequency noise intrudes in the ground line 44, there is a fear that the noise illustrated in FIG. 9E intrudes in the reading circuits RO via the ground line 44 or the like.

FIGS. 10A to 10F are graph views for illustrating noises in the case where the power supply circuit 41, the drive timing generating circuit 42, and the image data signal transfer circuit 43 are provided.

FIG. 10A shows a switching noise (low frequency noise) in the power supply line 56. FIG. 10B shows a switching noise (low frequency noise) in the ground line 55. FIG. 10C shows a state of the low frequency noise in the ground line 44. FIG. 10D shows a high frequency noise such as a digital signal generated on the control processing part 5 side and a noise generated due to skew of the signal. FIG. 10E shows a state of the high frequency noise in the signal line on the signal processing part 4 side. FIG. 10F shows a synthesized noise in the ground line 44.

If the power supply circuit 41 is provided, the ground line 44 of the signal processing part 4 and the ground line 55 of the control processing part 5 can be isolated. For that reason, as shown in FIG. 10C, it is possible to suppress the switching noise (low frequency noise) generated in the system power supply circuit 51 from intruding in the ground line 44.

Furthermore, if the drive timing generating circuit 42 and the image data signal transfer circuit 43 are provided, the drive control circuit 52 and the drive timing generating circuit 42 can be connected by two signal lines, and the read control circuit 53 and the image data transfer circuit 43 can also be connected by tow signal lines. For that reason, as shown in FIG. 10E, it is possible to suppress the high frequency noise generated on the control processing part 5 side from intruding in the signal line on the signal processing part 4 side. As a result, as shown in FIG. 10F, the noise intruding in the reading circuits RO or the like via the ground line 44 can be reduced drastically.

## Claims

1. A radiation detector (1) comprising:
an array substrate (2) including a plurality of control lines (2c1), a plurality of data lines (2c2) and a detection part (2b), the control lines (2c1) extend in a first direction, the data lines (2c2) extend in a second direction crossing the first direction, the detection part (2b) provided in each of a plurality of regions drawn by the plurality of control lines (2c1) and the plurality of data lines (2c2), electrically connected to the corresponding control line (2c1) of the control lines (2c1) and the corresponding data line (2c2) of the data lines (2c2), wherein the array substrate (2) detects radiation directly or in operation with a scintillator (3);
a gate driver (GD) electrically connected to each of the plurality of control lines (2c1), the gate driver (GD) for turning ON a thin film transistor (2b2) provided in the detection part (2b) by applying a voltage to the corresponding control line (2c1);
a drive control circuit (52) for generating a start signal and a clock signal for each of a plurality of the gate drivers (GD), and for converting a generated plurality of the start signals and a generated plurality of the clock signals to a first serial data;
a drive timing generating circuit (42) electrically connected between the drive control circuit (52) and the plurality of gate drivers (GD), for restoring the first serial data to a plurality of the start signals and a plurality of the clock signals, and for transmitting the restored start signals and the restored clock signals to the corresponding gate driver (GD) of the plurality of gate drivers (GD), the drive timing generating circuit (42) including : first inverters (42b1, 42b2) which invert the received first serial data and operational amplifiers (42d1, 42d2) which re-generate the start signals by calculating a difference between the start signals received via first capacitors (42c1, 42c2) and inverted first serial data received from the first inverters (42b1, 42b2) via second capacitors (42c2, 42c4), whereby the first capacitors (42c1, 42c2) and the second capacitors (42c3, 42c4) suppress noise including direct current component from intruding in the gate driver (GD), the start signals being for instructing a timing of scanning start, and the clock signals being for switching the control lines (2c1);
a reading circuit (RO) electrically connected to each of the plurality of data lines (2c2), the reading circuit (RO) for amplifying an image data signal and converting the amplified image data signal, which is an analog signal, into a digital signal;
an image data signal transfer circuit (43) for converting the converted image data signal from each of a plurality of the reading circuits (RO) to a second serial data, the image data signal transfer circuit (43) including second inverters (43d1, 43d2) which invert the received image data signal and second operational amplifiers (43f1, 43f2) which generate the second serial data by calculating a difference between the received image data which is received via third capacitors (43e1, 43e2) and the inverted image data signal received from the second inverters (43d1, 43d2) via fourth capacitors (43e2, 43e4), whereby the second capacitors (43e1, 43e2) and the fourth capacitors (43e3, 43e4) suppress noise including direct current component from intruding in the reading circuit (RO); and
a read control circuit (53) for restoring the second serial data to a plurality of the image data signals.

2. The radiation detector (1) according to claim 1, further comprising:
a system power supply circuit (51) for converting a DC voltage supplied from an outside to a prescribed DC voltage;
a DC-AC conversion part (41a) for converting a DC voltage supplied from the system power supply circuit (51) to an AC voltage;
a transformer (41b) having a primary side electrically connected to the DC-AC conversion part (41a), and having a secondary side electrically connected to the plurality of reading circuits (RO), the transformer (41b) isolates the DC-AC conversion part (41a) and the plurality of reading circuits (RO) in direct current, whereby the transformer (41b) suppresses noise including direct current component generated in the DC-AC conversion part (41a) from intruding in the plurality of reading circuits (RO); and
a rectifier (41c) electrically connected between a secondary side of the transformer (41b) and the plurality of reading circuits (RO).

## Patentansprüche

1. Ein Strahlendetektor (1), aufweisend:
ein Substratfeld (2) mit einer Vielzahl von Steuerleitungen (2c1), einer Vielzahl von Datenleitungen (2c2) und einem Erfassungsteil (2b), wobei sich die Steuerleitungen (2c1) in eine erste Richtung erstrecken, sich die Datenleitungen (2c2) in eine die erste Richtung kreuzende zweite Richtung erstrecken, wobei der in jedem einer Vielzahl von Gebieten vorgesehene Erfassungsteil (2b), die durch die Vielzahl von Steuerleitungen (2c1) und die Vielzahl von Datenleitungen (2c2) gezogen sind, mit der korrespondierenden Steuerleitung (2c1) der Steuerleitungen (2c1) und der korrespondierenden Datenleitung (2c2) der Datenleitungen (2c2) elektrisch verbunden sind, wobei das Substratfeld (2) Strahlung direkt oder in Betrieb mit einem Szintillator (3) erfasst;
einen Gate-Treiber (GD), der mit jeder der Vielzahl von Steuerleitungen (2c1) elektrisch verbunden ist, wobei der Gate-Treiber (GD) zum Einschalten eines Dünnfilmtransistors (2b2) dient, der in dem Erfassungsteil (2b) vorgesehen ist, indem eine Spannung an die korrespondierende Steuerleitung (2c1) angelegt wird;
eine Antriebssteuerschaltung (52) zum Erzeugen eines Startsignals und eines Taktsignals für jeden einer Vielzahl der Gate-Treiber (GD), und zum Umwandeln einer erzeugten Vielzahl der Startsignale und einer erzeugten Vielzahl der Taktsignale in erste serielle Daten;
eine Antriebszeit-Erzeugungsschaltung (42), die zwischen der Antriebssteuerschaltung (52) und der Vielzahl von Gate-Treibern (GD) elektrisch verbunden ist, um die ersten seriellen Daten in eine Vielzahl der Startsignale und eine Vielzahl der Taktsignale wiederherzustellen, und um die wiederhergestellten Startsignale und die wiederhergestellten Taktsignale an den korrespondierenden Gate-Treiber (GD) der Vielzahl von Gate-Treibern (GD) zu übertragen, wobei die Antriebszeit-Erzeugungsschaltung (42) umfasst: erste Wechselrichter (42b1, 42b2), die die empfangenen ersten seriellen Daten invertieren, und Operationsverstärker (42d1, 42d2), die die Startsignale erneut erzeugen, indem eine Differenz zwischen den über erste Kondensatoren (42c1, 42c2) empfangenen Startsignalen und über zweite Kondensatoren (42c2, 42c4) von den ersten Wechselrichtern (42b1, 42b2) empfangenen invertierten ersten seriellen Daten berechnet wird, wodurch die ersten Kondensatoren (42c1, 42c2) und die zweiten Kondensatoren (42c3, 42c4) Rauschen mit Gleichstromkomponenten daran hindern, in den Gate-Treiber (GD) zu gelangen, wobei die Startsignale zum Anweisen einer Zeitsteuerung eines Abtaststarts dienen, und die Taktsignale zum Umschalten der Steuerleitungen (2c1) dienen;
eine Leseschaltung (RO), die mit jeder der Vielzahl von Datenleitungen (2c2) elektrisch verbunden ist, wobei die Leseschaltung (RO) zum Verstärken eines Bilddatensignals und zum Umwandeln des verstärkten Bilddatensignals, das ein analoges Signal ist, in ein digitales Signal dient;
eine Bilddatensignal-Transferschaltung (43) zum Umwandeln des von jeder einer Vielzahl der Leseschaltungen (RO) umgewandelten Bilddatensignals in zweite serielle Daten, wobei die Bilddatensignal-Transferschaltung (43) umfasst:
zweite Wechselrichter (43d1, 43d2), die das empfangene Bilddatensignal invertieren, und zweite Operationsverstärker (43f1, 43f2), die die zweiten seriellen Daten erzeugen, indem eine Differenz zwischen den über dritte Kondensatoren (43e1, 43e2) empfangenen Bilddaten und dem von den zweiten Wechselrichtern (43d1, 43d2) über vierte Kondensatoren (43e2, 43e4) empfangenen invertieren Bilddatensignal berechnet wird, wodurch die zweiten Kondensatoren (43e1, 43e2) und die vierten Kondensatoren (43e3, 43e4) Rauschen mit einer Gleichstromkomponente daran hindern, in die Leseschaltung (RO) zu gelangen; und
eine Lesesteuerschaltung (53) zum Wiederherstellen der zweiten seriellen Daten in eine Vielzahl der Bilddatensignale.

2. Der Strahlendetektor (1) nach Anspruch 1, ferner aufweisend:
eine Systemenergiezufuhrschaltung (51) zum Umwandeln einer von außen zugeführten Gleichstromspannung auf eine vorgeschriebene Gleichstromspannung;
einen DC/AC-Umwandlungsteil (41a) zum Umwandeln einer von der Systemenergiezufuhrschaltung (51) zugeführten Gleichstromspannung in eine Wechselstromspannung;
einen Transformator (41b) mit einer Primärseite, die mit dem DC/AC-Umwandlungsteil (41a) elektrisch verbunden ist, und einer Sekundärseite, die mit der Vielzahl von Leseschaltungen (RO) elektrisch verbunden ist, wobei der Transformator (41b) den DC/AC-Umwandlungsteil (41a) und die Vielzahl von Leseschaltungen (RO) in Gleichstrom isoliert, wodurch der Transformator (41b) in dem DC/AC-Umwandlungsteil (41a) erzeugtes Rauschen mit einer Gleichstromkomponente daran hindert, in die Vielzahl von Leseschaltungen (RO) zu gelangen; und
einen Gleichrichter (41c), der zwischen einer Sekundärseite des Transformators (41b) und der Vielzahl von Leseschaltungen (RO) elektrisch verbunden ist.

## Revendications

1. Détecteur de rayonnement (1) comprenant :
un substrat de réseau (2) incluant une pluralité de lignes de commande (2c1), une pluralité de lignes de données (2c2), et une partie de détection (2b), dans lequel les lignes de commande (2c1) s'étendent dans une première direction, les lignes de données (2c2) s'étendent dans une seconde direction croisant la première direction, la partie de détection (2b) étant fournie dans chacune d'une pluralité de régions qui sont tracées par la pluralité de lignes de commande (2c1) et la pluralité de lignes de données (2c2), connectées électriquement à la ligne de commande (2c1) correspondante des lignes de commande (2c1) et à la ligne de données (2c2) correspondante des lignes de données (2c2), dans lequel le substrat de réseau (2) détecte un rayonnement, directement, ou en association avec un scintillateur (3) ;
un circuit d'attaque de grille (GD) connecté électriquement à chacune de la pluralité de lignes de commande (2c1), le circuit d'attaque de grille (GD) étant destiné à mettre sous tension un transistor à couche mince (2b2) fourni dans la partie de détection (2b), en appliquant une tension à la ligne de commande (2c1) correspondante ;
un circuit de commande d'attaque (52) destiné à générer un signal de départ et un signal d'horloge pour chaque circuit d'une pluralité des circuits d'attaque de grille (GD), et à convertir une pluralité générée de signaux de départ et une pluralité générée de signaux d'horloge en des premières données sérielles ;
un circuit de génération de temporisation d'attaque (42) connecté électriquement entre le circuit de commande d'attaque (52) et la pluralité de circuits d'attaque de grille (GD), destiné à restaurer les premières données sérielles en une pluralité de signaux de départ et une pluralité de signaux d'horloge, et à transmettre les signaux de départ restaurés et les signaux d'horloge restaurés, au circuit d'attaque de grille (GD) correspondant de la pluralité de circuits d'attaque de grille (GD), le circuit de génération de temporisation d'attaque (42) incluant : des premiers onduleurs (42b1, 42b2) qui inversent les premières données sérielles reçues, et des amplificateurs opérationnels (42d1, 42d2) qui régénèrent les signaux de départ en calculant une différence entre les signaux de départ reçus par l'intermédiaire de premiers condensateurs (42c1, 42c2) et des premières données sérielles inversées reçues en provenance des premiers onduleurs (42b1, 42b2) par l'intermédiaire de deuxièmes condensateurs (42c2, 42c4), moyennant quoi les premiers condensateurs (42c1, 42c2) et les deuxièmes condensateurs (42c3, 42c4) suppriment du bruit, incluant une composante de courant continu, pour empêcher toute intrusion dans le circuit d'attaque de grille (GD), les signaux de départ étant destinés à instruire une temporisation de début de balayage, et les signaux d'horloge étant destinés à commuter les lignes de commande (2c1) ;
un circuit de lecture (RO) connecté électriquement à chaque ligne de la pluralité de lignes de données (2c2), le circuit de lecture (RO) étant destiné à amplifier un signal de données d'image et à convertir le signal de données d'image amplifié, lequel est un signal analogique, en un signal numérique ;
un circuit de transfert de signal de données d'image (43) destiné à convertir le signal de données d'image converti en provenance de chaque circuit de la pluralité des circuits de lecture (RO), en des secondes données sérielles, le circuit de transfert de signal de données d'image (43) incluant des seconds onduleurs (43d1, 43d2) qui inversent le signal de données d'image reçu, et des seconds amplificateurs opérationnels (43f1, 43f2) qui génèrent les secondes données sérielles, en calculant une différence entre les données d'image reçues, qui sont reçues par l'intermédiaire de troisièmes condensateurs (43e1, 43e2), et le signal de données d'image inversé, reçu en provenance des seconds onduleurs (43d1, 43d2), par l'intermédiaire de quatrièmes condensateurs (43e2, 43e4), moyennant quoi les deuxièmes condensateurs (43e1, 43e2) et les quatrièmes condensateurs (43e3, 43e4) suppriment du bruit, incluant une composante de courant continu, pour empêcher toute intrusion dans le circuit de lecture (RO) ; et
un circuit de commande de lecture (53) destiné à restaurer les secondes données sérielles sur une pluralité de signaux de données d'image.

2. Détecteur de rayonnement (1) selon la revendication 1, comprenant en outre :
un circuit d'alimentation électrique de système (51) destiné à convertir une tension continue fournie depuis l'extérieur, en une tension continue prescrite ;
une partie de conversion de tension continue en tension alternative (41a) destiné à convertir une tension continue, fournie à partir du circuit d'alimentation électrique de système (51), en une tension alternative ;
un transformateur (41b) présentant un côté primaire connecté électriquement à la partie de conversion de tension continue en tension alternative (41a), et présentant un côté secondaire connecté électriquement à la pluralité de circuits de lecture (RO), dans lequel le transformateur (41b) isole la partie de conversion de tension continue en tension alternative (41a) et la pluralité de circuits de lecture (RO) en courant continu, moyennant quoi le transformateur (41b) supprime du bruit, incluant une composante de courant continu générée dans la partie de conversion de tension continue en tension alternative (41a), pour empêcher toute intrusion dans la pluralité de circuits de lecture (RO) ; et
un redresseur (41c) connecté électriquement entre un côté secondaire du transformateur (41b) et la pluralité de circuits de lecture (RO).
